# EUROPEAN PATENT APPLICATION

(11) **EP 2 023 417 A2**
(43) Date of publication of application: **11.02.2009**
(21) Application number: 08151632.0
(22) Date of filing: 19.02.2008
(51) Int. Cl.: H01L 41/24

(54) **Method of Poling Piezoelectric Actuator**

(30) Priority: 09.07.2007 KR 20070068821
(71) Applicant: Samsung Electronics Co., Ltd., Suwon-si Gyeonggi-do 443-742 (KR)
(72) Inventor: Lim, Seung-mo, Gyeonggi-do (KR); Lee, Tae-kyung, Gyeonggi-do (KR); Lee, Hwa-sun, Gyeonggi-do (KR)
(74) Representative: Greene, Simon Kenneth

(57) **Abstract**

A method of poling a piezoelectric actuator, which can improve the uniformity of a plurality of piezoelectric actuators. In the method, a plurality of piezoelectric actuators are prepared for poling. Then, at least two preliminary poling processes are performed on the prepared piezoelectric actuators under different preliminary voltages and displacements of the piezoelectric actuators subjected to each of the at least two poling processes are measured. A relationship between a voltage and a displacement for each of the piezoelectric actuators is established. Poling voltages are calculated so that the piezoelectric actuators can have the same target displacement. Format poling is performed on the piezoelectric actuators under the calculated poling voltages. The displacements of the piezoelectric actuators, which have completed the formal poling, are measured.

## Description

### BACKGROUND OF THE INVENTION

The present general inventive concept relates to a piezoelectric actuator, and more particularly, to a method of poling a piezoelectric actuator, which can improve the uniformity of a plurality of piezoelectric actuators.

Piezoelectric actuators, which generate a driving force using the piezoelectric characteristic of a piezoelectric material, are used in various applications such as inkjet heads, micropumps, and fluidics systems.

Piezoelectric materials are subjected to poling, which orients dipoles in one direction, thereby completing piezoelectric actuators as driving elements.

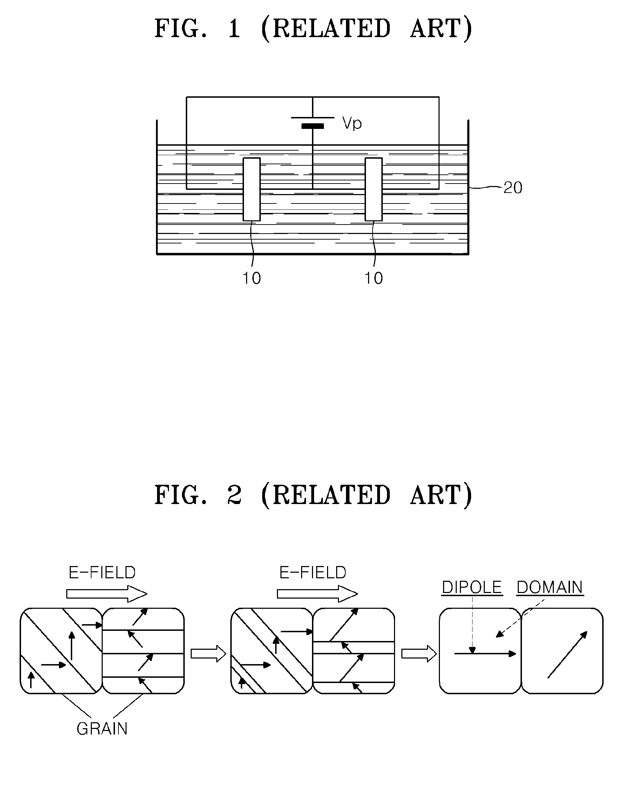

FIG. 1 is a cross-sectional view illustrating a conventional method of poling a bulk piezoelectric material. FIG. 2 illustrates a process of poling in a bulk piezoelectric material.

Referring to FIG. 1, the conventional method of poling the bulk piezoelectric material includes applying a poling voltage Vp to both ends of a bulk piezoelectric material 10 in a silicon oil bath 20. The poling voltage Vp may be the maximum direct current (DC) voltage that can be used without breakdown.

Referring to FIG. 2, domains with differently oriented dipoles are present in a grain of the bulk piezoelectric material 10. When the poling voltage Vp is applied to the bulk piezoelectric material 10, an electric field is generated and dipoles of adjacent domains are oriented in one direction. As the dipoles in the grain are oriented in one direction, a domain area is increased, and also dipoles of adjacent domains are also oriented in one direction or similar direction.

Piezoelectric actuators include a lower electrode and an upper electrode each formed of a conductive metal material, and a piezoelectric layer formed of a piezoelectric material and disposed between the lower electrode and the upper electrode. Piezoelectric actuators acquire piezoelectric properties after undergoing a poling process. Poling is usually performed by applying a poling voltage between a lower electrode and an upper electrode in silicon oil or air.

Various devices, such as inkjet heads, micropumps, and fluidics systems, may employ a plurality of piezoelectric actuators. For example, piezoelectric inkjet heads employ a plurality of piezoelectric actuators corresponding to a plurality of pressure chambers. Devices employing a plurality of piezoelectric actuators may require that the piezoelectric characteristics of the piezoelectric actuators be uniform. That is, when the same driving voltage is applied to the piezoelectric actuators, the piezoelectric actuators may be required to generate the same displacement. Also, when a plurality of devices each employ at least one piezoelectric actuator, the devices may be required to have the same piezoelectric characteristics.

As described above, when a plurality of piezoelectric actuators are used, conventional poling is performed on the plurality of piezoelectric actuators under the same poling conditions, e.g., the same poling voltage and/or the same voltage application time.

However, piezoelectric actuators have variations caused during manufacturing for various reasons such as production material, manufacturing equipment, and/or workplace environment. Accordingly, when the piezoelectric actuators having the variations are subjected to poling under the same conditions, the piezoelectric characteristics of the piezoelectric actuators are not uniform.

Many important attempts and studies have been made to make uniform the piezoelectric characteristics of a plurality of piezoelectric actuators by improving a manufacturing process, or to make uniform the dimensions of the actuators and the coatings of piezoelectric materials using expensive equipment. However, these attempts and studies have not yet been satisfactory due to limitations such as variations in production material, manufacturing equipment, and workplace environment.

### SUMMARY OF THE INVENTION

The present general inventive concept provides a method of poling a piezoelectric actuator, which can increase uniformity of the piezoelectric characteristics of a plurality of piezoelectric actuators.

Additional aspects and utilities of the present general inventive concept will be set forth in part in the description which follows and, in part, will be obvious from the description, or may be learned by practice of the general inventive concept.

The foregoing and/or other aspects and utilities of the present general inventive concept may be achieved by providing a method of poling piezoelectric actuators, the method including preparing a plurality of piezoelectric actuators, performing at least two preliminary poling processes on the plurality of prepared piezoelectric actuators such that each preliminary poling process is under a different poling condition and measuring at least one piezoelectric characteristic of each of the plurality of piezoelectric actuators subjected to each of the at least two preliminary poling processes, establishing a relationship between a poling condition and a piezoelectric characteristic for each of the plurality of piezoelectric actuators, calculating a poling condition for each prepared piezoelectric actuator so that the plurality of piezoelectric actuators have substantially the same target piezoelectric characteristic, performing formal poling on each of the plurality of piezoelectric actuators under the calculated poling conditions, and measuring at least one piezoelectric characteristic of each of the plurality of piezoelectric actuators which have completed the formal poling.

The operation of preparing a plurality of piezoelectric actuators may include preparing a device which includes a plurality of piezoelectric actuators to be poled or preparing a plurality of devices where each device may include at least one piezoelectric actuator. The device may be at least one of an inkjet head, a micropump, or a fluidics system.

When the piezoelectric characteristics measured in the measuring at least one piezoelectric characteristic operation results in a value that exceeds a target uniformity value, then an additional method of measuring may be performed including performing at least two additional preliminary poling processes on each of the piezoelectric actuators under a different poling condition for each additional preliminary poling process and measuring at least one piezoelectric characteristic of each piezoelectric actuator, establishing a new relationship between a poling condition and a piezoelectric characteristic for each of the plurality of piezoelectric actuators, calculating a new poling condition so that the piezoelectric actuators can have substantially an identical target piezoelectric characteristic, performing formal poling on each piezoelectric actuator under each newly calculated poling condition, and measuring at least one piezoelectric characteristic of each of the piezoelectric actuators which have completed the formal poling under each newly calculated poling condition.

A poling condition in the performing at least two additional preliminary poling processes operation may be different from a poling condition in a previous operation utilizing a poling condition.

Each polling condition may be a voltage level, and each piezoelectric characteristic may be a displacement value.

The performing at least two preliminary poling processes operation may include performing a first preliminary poling on each piezoelectric actuator under a first preliminary voltage, performing a first displacement measurement to measure the displacement of each piezoelectric actuator which has completed the first preliminary poling, performing a second preliminary poling on each piezoelectric actuator under a second preliminary voltage, and performing a second displacement measurement to measure the displacement of each piezoelectric actuator which has completed the second preliminary poling.

The second preliminary voltage may be greater than the first preliminary voltage.

The first preliminary poling may be performed under a condition where the first preliminary voltage is uniformly applied to the plurality of piezoelectric actuators, and the second preliminary poling may be performed under a condition where the second preliminary voltage is uniformly applied to the plurality of piezoelectric actuators.

Each first displacement measurement and each second displacement measurement may be to measure the displacement of each piezoelectric actuator to be performed under a condition where the same driving voltage is applied to the plurality of piezoelectric actuators.

The performing at least two preliminary poling processes operation may further include performing a third preliminary poling on the plurality of piezoelectric actuators under a third preliminary voltage, and performing a third displacement measurement to measure the displacement of each piezoelectric actuator which has completed the third preliminary poling.

The third preliminary voltage may be greater than the second preliminary voltage, and the second preliminary voltage may be greater than the first preliminary voltage.

The establishing a relationship between a poling condition and a piezoelectric characteristic operation may include establishing a relationship between a voltage and a displacement value for each of the plurality of piezoelectric actuators by using each voltage applied to the plurality of piezoelectric actuators and the displacement of each piezoelectric actuator measured in the performing at least two preliminary poling processes operation.

The calculating a poling condition operation may include calculating a poling voltage to be applied to the plurality of piezoelectric actuators so that the plurality of piezoelectric actuators may have substantially the same target displacement value by using the relationships established in the establishing a relationship operation. The calculated poling voltages to be applied to the plurality of piezoelectric actuators may be different from one another.

The performing formal poling operation may include performing a formal poling by applying each calculated poling voltage to be applied to the plurality of piezoelectric actuators.

The measuring at least one piezoelectric characteristic operation may include measuring the displacement of each piezoelectric actuator under a condition where the same driving voltage is applied to the plurality of piezoelectric actuators.

The foregoing and/or other aspects and utilities of the present general inventive concept may also be achieved by providing a method of poling a piezoelectric device including applying a first voltage and then a second voltage which is greater than the first voltage to the piezoelectric device, measuring a first and a second displacement of the piezoelectric device caused by the respective application of the first and the second applied voltages, determining a linear relationship between the first and second applied voltages and the measured first and second displacements of the piezoelectric device, and applying a predetermined poling voltage to the device to achieve a predetermined displacement of the piezoelectric device, where the predetermined poling voltage is a function of the determined linear relationship.

In the method, the piezoelectric device may be a piezoelectric actuator.

The method may further include applying at least one additional voltage to the piezoelectric device which is greater than the first and second voltages and measuring an additional displacement of the piezoelectric device caused by application of the at least one additional applied voltage.

The defining the linear relationship may include a defined linear relationship between the first and second applied voltages and the measured first and second displacements of the piezoelectric device and between each additional applied voltage and a unique displacement of the piezoelectric device associated with each additional applied voltage.

The foregoing and/or other aspects and utilities of the present general inventive concept may also be achieved by providing a method to achieve a desired displacement of a piezoelectric actuator, including applying a plurality of increasingly greater voltages to the actuator, measuring a unique displacement of the actuator for each of the applied plurality of increasingly greater voltages, defining a relationship between the applied plurality of increasingly greater voltages and each measured unique displacement of the actuator, and applying a poling voltage to the actuator to achieve a predetermined displacement of the actuator such that the poling voltage is a function of the defined relationship.

The method where a polarity of a current associated with each of the applied plurality of increasingly greater voltages may be the same.

The method where the defined relationship may be a linear relationship.

### BRIEF DESCRIPTION OF THE DRAWINGS

These and/or other aspects and utilities of the present general inventive concept will become apparent and more readily appreciated from the following description of the embodiments, taken in conjunction with the accompanying drawings of which:
FIG. 1 is a cross-sectional view illustrating a conventional method of poling a bulk piezoelectric material;
FIG. 2 illustrates the conventional process of poling in a bulk piezoelectric material;
FIG. 3 illustrates a perspective view of a conventional inkjet head;
FIG. 4 is a cross-sectional view taken along line A-A' of the conventional inkjet head of FIG. 3;
FIG. 5 is a flowchart illustrating a method of poling a piezoelectric actuator according to an embodiment of the present general inventive concept;
FIG. 6 is a graph illustrating a relationship between a voltage and a displacement for each of a plurality of piezoelectric actuators according to an embodiment of the present general inventive concept;
FIG. 7 is a graph illustrating a comparison of the displacements of a plurality of piezoelectric actuators subjected to a poling method according to the present general inventive concept (lower trace) and the displacements of a plurality of actuators subjected to a conventional poling method (upper trace); and
FIG. 8 is a graph illustrating an average displacement for a plurality of piezoelectric actuators for each of six inkjet heads at each operation in the poling method when the six inkjet heads are subjected to a poling method according to the present general inventive concept.

### DETAILED DESCRIPTION OF THE PREFERRED EMBODIMENTS

Reference will now be made in detail to the embodiments of the present general inventive concept, examples of which are illustrated in the accompanying drawings, wherein like reference numerals refer to the like elements throughout. The embodiments are described below in order to explain the present general inventive concept by referring to the figures.

A method of poling a piezoelectric actuator according to the present general inventive concept can be applied to various kinds of devices such as inkjet heads, micropumps, and fluidics systems. However, for clarity and ease of explanation, a case where the poling method is applied to a piezoelectric inkjet head having a plurality of piezoelectric actuators will be exemplarily explained. In general, inkjet heads are devices to print a predetermined black and white or color image by ejecting minute droplets of ink on desired areas of a recording medium (e.g., printing paper). In particular, piezoelectric inkjet heads eject ink using a pressure applied to the ink when a piezoelectric actuator of the inkjet head is deformed.

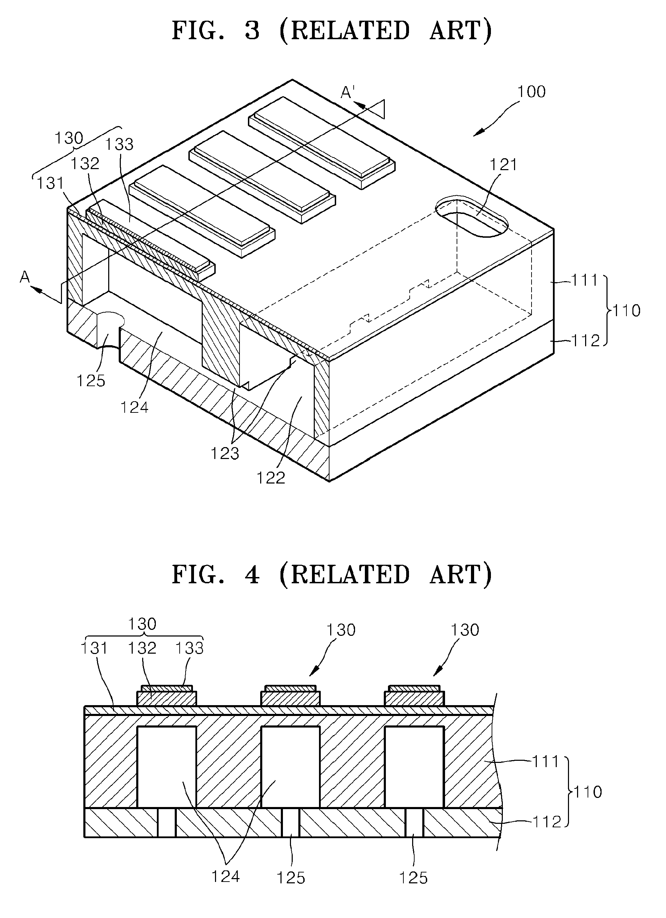

FIG. 3 is a perspective view of a conventional piezoelectric inkjet head 100. FIG. 4 is a cross-sectional view taken along line A-A' of the conventional inkjet head 100 of FIG. 3.

Referring to FIGS. 3 and 4, the piezoelectric inkjet head 100 includes a passage plate 110 in which an ink passage is formed, and a plurality of piezoelectric actuators 130 formed on a top surface of the passage plate 110.

The passage plate 110 may include a first substrate 111, and a second substrate 112 bonded to a bottom surface of the first substrate 111. Both the first substrate 111 and the second substrate 112 may be silicon substrates. A manifold 122, which is a common ink passage, and a plurality of pressure chambers 124 and a plurality of restrictors 123, which are individual ink passages, are formed in the first substrate 111. A plurality of nozzles 125, which are individual ink passages, are formed in the second substrate 112. The pressure chambers 124, formed in the first substrate 111, are filled with ink to be ejected, and are arranged in one direction at predetermined intervals. The manifold 122 supplies ink to the pressure chambers 124 via restrictors 123, and is disposed near a side of the pressure chambers 124 in parallel to the arrangement direction of the pressure chambers 124. Ink supplied from an ink reservoir (not illustrated) through an ink supply hole 121 is contained in the manifold 122. The restrictors 123 are paths connecting the manifold 122 and the pressure chambers 124 to allow for ink to flow from the manifold 122 to the plurality of pressure chambers 124.

The nozzles 125 formed in the second substrate 112 are respectively connected to the pressure chambers 124, and allow ink droplets to be ejected from the pressure chambers 124 through the nozzles 125.

The piezoelectric actuators 130 are formed on the top surface of the passage plate 110, that is, on a top surface of the first substrate 111, respectively corresponding to the pressure chambers 124. The piezoelectric actuators 130 change a pressure in the pressure chambers 124 by moving and vibrating the first substrate 111 disposed over the pressure chambers 124. Each of the piezoelectric actuators 130 includes a lower electrode 131 covering the top surface of the first substrate 111, a piezoelectric layer 132 formed on the lower electrode 131, and an upper electrode 133 formed on the piezoelectric layer 132. The lower electrode 131 may be formed by depositing a conductive metal material on the top surface of the first substrate 111. The piezoelectric layer 132 may be formed by coating and sintering a certain piezoelectric material, for example, a lead ziconate titanate (PZT) ceramic paste, on the lower electrode 131. The upper electrode 133 may be formed by coating and sintering a conductive metal paste on the piezoelectric layer 132.

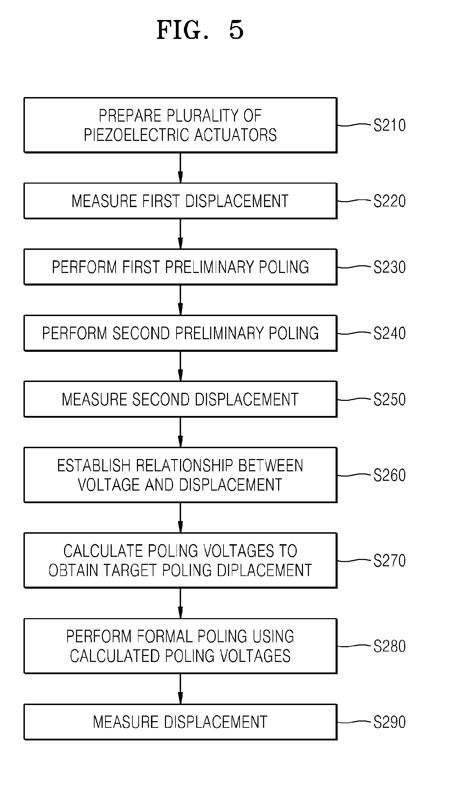

FIG. 5 is a flowchart illustrating a method of poling a piezoelectric actuator according to an embodiment of the present general inventive concept.

In operation S210, a plurality of piezoelectric actuators are prepared.

The conventional piezoelectric inkjet head of FIGS. 3 and 4 or another device, e.g., a micropump or a fluidics system, which includes a plurality of piezoelectric actuators, may be prepared for poling. Alternatively, a plurality of devices each having at least one piezoelectric actuator may be prepared for poling. The prepared piezoelectric actuators may have variations caused during manufacturing for various reasons as described above.

Then, the prepared piezoelectric actuators may be subjected to at least two preliminary poling processes under different poling conditions. The piezoelectric characteristics of the piezoelectric actuators, subjected to each of the at least two preliminary poling processes, may be measured.

The poling conditions at each poling process may include a voltage level and a poling time, and in the present embodiment, the poling condition may be a voltage level. The measured piezoelectric characteristics may be the displacement of each of the piezoelectric actuators under at least one condition during at least one process.

In operation S220, first preliminary poling is performed on the prepared piezoelectric actuators. The first preliminary poling is performed under a condition where a first preliminary voltage V1 is uniformly applied to the piezoelectric actuators. The first preliminary voltage V1 is sufficiently lower than a conventional poling voltage.

In operation S230, the first displacement of each of the piezoelectric actuators, which have completed the first preliminary poling operation, is measured. The first displacement measurement is performed under a condition where a predetermined driving voltage Vd is uniformly applied to the piezoelectric actuators. The driving voltage Vd may be set based on various factors including a material included in the piezoelectric actuator, the size of each of the piezoelectric actuators, and the type and size of the device in which the piezoelectric actuators are included. For example, the driving voltage Vd may be 35 volts.

In operation S240, second preliminary poling is performed on the piezoelectric actuators. The second preliminary poling is performed under a condition where a second preliminary voltage V2 is uniformly applied to the piezoelectric actuators. The second preliminary voltage V2 may be lower than the conventional poling voltage and greater than the first preliminary voltage V1.

In operation S250, the second displacements of the piezoelectric actuators, which have completed the second preliminary poling, are measured. The second displacement measurement is performed under the condition where the driving voltage Vd is uniformly applied to the piezoelectric actuators.

In order to establish a relationship between a voltage and a displacement for each of the piezoelectric actuators, which will be explained below, the two preliminary poling processes and two displacement measurements may be required. In order to establish a more accurate voltage/displacement relationship, three or more preliminary poling processes and three or more displacement measurements may be required. For example, when a third preliminary poling is performed, a third preliminary voltage V3 may be used which is greater than the second preliminary voltage V2 and lower than the conventional poling voltage Vp. A third displacement measurement may also be performed under a condition where the driving voltage Vd is uniformly applied to the piezoelectric actuators. By gradually increasing the level of a preliminary voltage applied to the actuators, at least two, and possibly three or more, preliminary poling processes may be performed.

In operation S260, a relationship between a voltage and a displacement for each of the piezoelectric actuators is established.

Since at least two preliminary voltages were applied to the piezoelectric actuators and at least two displacements for each of the piezoelectric actuators were measured in the previous operations, a relationship between a voltage and a displacement for each of the piezoelectric actuators can be established using the values of the two voltages and the two measured displacements.

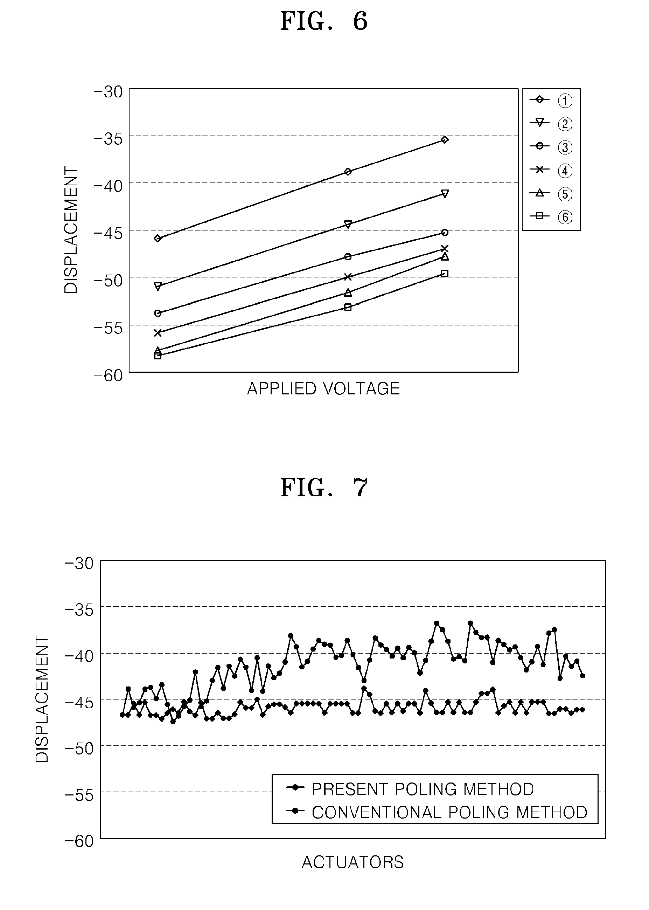

FIG. 6 is a graph illustrating three displacement values obtained by performing three preliminary poling processes on six piezoelectric actuators. The six piezoelectric actuators are indicated by numbers ① through ⑥.

Referring to the graph of FIG. 6, a displacement for each piezoelectric actuator increases in proportion to a voltage applied to each of the six piezoelectric actuators. That is, the greater the applied voltage, the greater the displacement. Accordingly, the following linear relationships can be obtained. In the relationships, y represents a displacement value and x denotes a voltage value.
First piezoelectric actuator ①; y = 0.1782x - 25.569
Second piezoelectric actuator ② ; y = 0.1658x - 31.853
Third piezoelectric actuator ③; y = 0.1449x - 37.105
Fourth piezoelectric actuator ④; y = 0.1463x - 39.004
Fifth piezoelectric actuator ⑤; y = 0.1703x - 38.537
Sixth piezoelectric actuator ⑥; y = 0.1407x - 42.237

In operation S270, poling voltages Vp enabling the piezoelectric actuators to have substantially the same target displacement are calculated.

By using the relationships established in operation S260, poling voltages Vp, which are applied to the piezoelectric actuators in order for the piezoelectric actuators to have substantially the same target displacement, can be calculated. The calculated poling voltages Vp, which are applied to the individual piezoelectric actuators, may be different from one another.

In operation S280, formal poling is performed by applying the calculated poling voltages Vp to the respective piezoelectric actuators. At this point, the calculated poling voltages Vp, which are respectively applied to the piezoelectric actuators, may be different from one another as described above.

In operation S290, the displacements of the piezoelectric actuators, which have completed the formal poling process, are measured. The displacement measurement is performed under a condition where the driving voltage Vd is uniformly applied to the piezoelectric actuators. The displacement measurement can detect whether the poling method has been successfully performed and whether the piezoelectric characteristics, that is, the displacements, of the piezoelectric actuators are substantially uniform.

If the uniformity of the displacements measured in operation S290 exceeds a target uniformity, operations S220 through S290 may be repeated to achieve greater uniformity among the plurality of piezoelectric actuators being processed. In this situation, preliminary voltages, which are applied to the piezoelectric actuators in repeated operations S220 and S240, should be different from the first preliminary voltage V1 and the second preliminary voltage V2 previously applied such that a more accurate relationship between a voltage and a displacement can be established by obtaining more displacement values in a repeated operation S260 and thus more accurate poling voltages Vp can be calculated in a repeated operation S270.

Thus, the uniformity of the piezoelectric characteristics of the piezoelectric actuators can be further improved by repeating operations S220 through S290 as described above.

FIG. 7 is a graph illustrating the displacement values of a plurality of piezoelectric actuators subjected to a poling method according to the present general inventive concept (lower trace), and the displacement values of a plurality of piezoelectric actuators subjected to a conventional poling method (upper trace). In the poling method according to the present general inventive concept, a target displacement was set to be 45 nm, and in the conventional poling method, a direct current (DC) voltage of 90 volts was uniformly applied to the piezoelectric actuators.

Data of the two traces illustrated in FIG. 7 is given below in Table 1.

**Table 1**

| | Conventional poling method (Upper Trace) | Poling method of the present general inventive concept (Lower Trace) |
|---|---|---|
| Average displacement (nm) | -42.22 | -45.31 |
| Standard deviation (STD) | 3.45 | 1.36 |
| %STD | 8.18 | 3.10 |
| Uniformity (% of range) | 37.6 | 11.73 |

In Table 1, the percent of standard deviation (%STD) is a value obtained by dividing a standard deviation (STD) by an average displacement and then representing the result in terms of percentage (%). Uniformity (% of range) is a value obtained by dividing a difference between a maximum displacement and a minimum displacement for the piezoelectric actuators by an average displacement of the piezoelectric actuators and then representing the result in terms of percentage (%).

Referring to the graph of FIG. 7 and Table 1, while the displacements of the piezoelectric actuators subjected to the conventional poling method (upper trace) have a relatively high standard deviation and a uniformity (% of range) of 37.6 %, the displacements of the piezoelectric actuators subjected to the poling method according to the present general inventive concept (lower trace) have a relatively lower standard deviation and a uniformity (% of range) of 11.73 % which is much lower than the 37.6 % of range of the conventional poling method.

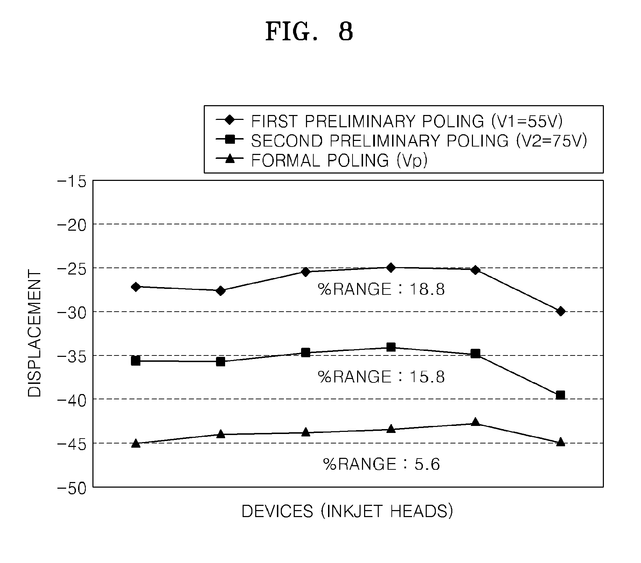

FIG. 8 is a graph illustrating an average displacement for a plurality of piezoelectric actuators of each of six inkjet heads at each operation described above when the six inkjet heads are subjected to a poling method according to an embodiment of the present general inventive concept.

Referring to the graph of FIG. 8, the piezoelectric characteristics of the inkjet heads has a uniformity (% of range) of 18.8 % after a first preliminary poling process, 15.8 % after a second preliminary poling process, and 5.6 % after a formal poling process.

Accordingly, the poling method according to the present general inventive concept can also substantially improve the uniformity of the piezoelectric characteristics of piezoelectric actuators of the plurality of devices.

As described above, since the method of poling a piezoelectric actuator according to the present general inventive concept calculates poling voltages from relationships between voltages and displacements established during preliminary poling processes so that a target displacement for a plurality of piezoelectric actuators can be obtained, and then performs poling on the piezoelectric actuators by respectively applying the calculated poling voltages to the piezoelectric actuators, the uniformity of the piezoelectric characteristics of the piezoelectric actuators can be improved. Thus, the uniformity of the characteristics of a plurality of piezoelectric actuators included within a device, and the uniformity of the characteristics of a plurality of devices each of which include a piezoelectric actuator, can be substantially improved.

Although a few embodiments of the present general inventive concept have been illustrated and described, it will be appreciated by those skilled in the art that changes may be made in these embodiments without departing from the principles of the general inventive concept, the scope of which is defined in the appended claims and their equivalents. For example, the present general inventive concept may be applied to various devices which include piezoelectric actuators.

## Claims

1. A method of poling piezoelectric actuators, the method comprising:
preparing a plurality of piezoelectric actuators;
performing at least two preliminary poling processes on the plurality of prepared piezoelectric actuators such that each preliminary poling process is under a different poling condition and measuring at least one piezoelectric characteristic of each of the plurality of piezoelectric actuators subjected to each of the at least two preliminary poling processes;
establishing a relationship between a poling condition and a piezoelectric characteristic for each of the plurality of piezoelectric actuators;
calculating a poling condition for each prepared piezoelectric actuator so that the plurality of piezoelectric actuators have substantially the same target piezoelectric characteristic;
performing formal poling on each of the plurality of piezoelectric actuators under the calculated poling conditions; and
measuring at least one piezoelectric characteristic of each of the plurality of piezoelectric actuators which have completed the formal poling.

2. The method of claim 1, wherein the preparing the plurality of piezoelectric actuators operation comprises:
preparing a device which includes a plurality of piezoelectric actuators to be poled.

3. The method of claim 2, wherein the device is at least one of an inkjet head, a micropump, or a fluidics system.

4. The method of any preceding claim, wherein when the measuring the at least one piezoelectric characteristic of each of the piezoelectric actuators operation results in a value that exceeds a target uniformity value then an additional method of measuring is performed, comprising:
performing at least two additional preliminary poling processes on each of the piezoelectric actuators under a different poling condition for each additional preliminary poling process and measuring at least one piezoelectric characteristic of each piezoelectric actuator;
establishing a new relationship between a poling condition and a piezoelectric characteristic for each of the plurality of piezoelectric actuators;
calculating a new poling condition so that the piezoelectric actuators can have substantially an identical target piezoelectric characteristic;
performing formal poling on each piezoelectric actuator under each newly calculated poling condition; and
measuring at least one piezoelectric characteristic of each of the piezoelectric actuators which have completed the formal poling under each newly calculated poling condition.

5. The method of claim 4, wherein a poling condition in the performing at least two additional preliminary poling processes operation is different from a poling condition of claim 1.

6. The method of any preceding claim, wherein each poling condition is a voltage level, and each piezoelectric characteristic is a displacement.

7. The method of claim 6, wherein the performing at least two preliminary poling processes operation comprises:
performing a first preliminary poling on each piezoelectric actuator under a first preliminary voltage;
performing a first displacement measurement to measure the displacement of each piezoelectric actuator which has completed the first preliminary poling;
performing a second preliminary poling on each piezoelectric actuator under a second preliminary voltage; and
performing a second displacement measurement to measure the displacement of each piezoelectric actuator which has completed the second preliminary poling.

8. The method of claim 7, wherein the second preliminary voltage is greater than the first preliminary voltage.

9. The method of claim 7 or 8, wherein the first preliminary poling is performed under a condition where the first preliminary voltage is uniformly applied to the plurality of piezoelectric actuators, and the second preliminary poling is performed under a condition where the second preliminary voltage is uniformly applied to the plurality of piezoelectric actuators.

10. The method of claim 7, 8 or 9, wherein each first displacement measurement and each second displacement measurement is to measure the displacement of each piezoelectric actuator and is performed under a condition where the same driving voltage is applied to the plurality of piezoelectric actuators.

11. The method of claim 7, 8, 9 or 10, wherein the performing at least two preliminary poling processes operation further comprises:
performing a third preliminary poling on the plurality of piezoelectric actuators under a third preliminary voltage; and
performing a third displacement measurement to measure the displacement of each piezoelectric actuator which has completed the third preliminary poling.

12. The method of claim 11, wherein the third preliminary voltage is greater than the second preliminary voltage, and the second preliminary voltage is greater than the first preliminary voltage.

13. The method of any of claims 6 to 12, the establishing a relationship between a poling condition and a piezoelectric characteristic comprises:
establishing a relationship between a voltage and a displacement value for each of the plurality of piezoelectric actuators by using each voltage applied to the plurality of piezoelectric actuators and the displacement of each piezoelectric actuator measured in the performing at least two preliminary poling processes operation.

14. The method of any of claims 6 to 13, wherein the calculating a poling condition operation comprises:
calculating a poling voltage to be applied to the plurality of piezoelectric actuators so that the plurality of piezoelectric actuators have substantially the same target displacement value by using the relationships established in the establishing a relationship between a poling condition and a piezoelectric characteristic operation.

15. The method of claim 14, wherein each calculated poling voltage to be applied to the plurality of piezoelectric actuators is different.

16. The method of any of claims 6 to 15, wherein the performing formal poling operation comprises:
performing a formal poling by applying each poling voltage calculated in the calculating a poling condition operation to the plurality of piezoelectric actuators.

17. The method of any of claims 6 to 16, wherein in the measuring at least one piezoelectric characteristic operation the measuring at least one piezoelectric characteristic comprises:
measuring the displacement of each piezoelectric actuator under a condition where the same driving voltage is applied to the plurality of piezoelectric actuators.

18. The method of any preceding claim, wherein the preparing a plurality of piezoelectric actuators comprises:
preparing a plurality of devices each including at least one piezoelectric actuator to be poled.

19. A method of poling a piezoelectric device, comprising:
applying a first voltage and then a second voltage which is greater than the first voltage to the piezoelectric device;
measuring a first and a second displacement of the device caused by the respective applications of the first and the second applied voltages;
determining a linear relationship between the first and second applied voltages and the measured first and second displacements of the piezoelectric device; and
applying a predetermined poling voltage to the piezoelectric device to achieve a predetermined displacement of the piezoelectric device, where the predetermined poling voltage is a function of the determined linear relationship.

20. The method of claim 19, wherein the piezoelectric device is a piezoelectric actuator.

21. The method of claim 19 or 20, further comprising:
applying at least one additional voltage to the piezoelectric device which is greater than the first and second voltages; and
measuring an additional displacement of the piezoelectric device caused by application of the at least one additional applied voltage.

22. The method of claim 21, wherein the determining the linear relationship includes a defined linear relationship between the first and second applied voltages and the measured first and second displacements of the piezoelectric device and between each additional applied voltage and a unique displacement of the piezoelectric device associated with each additional applied voltage.

23. A method to achieve a desired displacement of a piezoelectric actuator, comprising:
applying a plurality of increasingly greater voltages to the actuator;
measuring a unique displacement of the actuator for each of the applied plurality of increasingly greater voltages;
defining a relationship between the applied plurality of increasingly greater voltages and each measured unique displacement of the actuator; and
applying a poling voltage to the actuator to achieve a predetermined displacement of the actuator such that the poling voltage is a function of the defined relationship.

24. The method of claim 23, wherein a polarity of a current associated with each of the applied plurality of increasingly greater voltages is the same.

25. The method of claim 23 or 24, wherein the defined relationship is a linear relationship.
